# EUROPÄISCHE PATENTANMELDUNG

(11) **EP 1 172 819 A1**
(43) Veröffentlichungstag der Anmeldung: **16.01.2002**
(21) Anmeldenummer: 01113285.9
(22) Anmeldetag: 31.05.2001
(51) Int. Cl.: G11C 7/06, G11C 7/10, G11C 11/4091

(54) **Schaltungsanordnung zum Lesen und Schreiben von Information an einem Speicherzellenfeld**

(30) Priorität: 14.07.2000 DE 10034255
(71) Anmelder: Infineon Technologies AG, 81669 München (DE)
(72) Erfinder: Johnson, Bret, 81737 München (DE); Plättner, Eckhard, 81737 München (DE); Schneider, Helmut, 80993 München (DE)
(74) Vertreter: Patentanwaltskanzlei WILHELM & BECK

(57) **Zusammenfassung**

Zum Lesen und Schreiben binärer Information an einem Speicherzellenfeld, das eine matrixförmige Anordnung aus Zeilen und Spalten von Speicherzellen bildet, ist eine Mehrzahl von Schreib/Lese-Schaltungen (LV2) vorgesehen, deren jede ein Latch-Flipflop (T1-T4) mit mindestens einem Datenanschluß (BA, BB) enthält, der einerseits mit einer zugeordneten, spaltenbezogenen Bitleitung und andererseits über eine Torschaltung (T7, T8) mit einer Datenleitung (DA, DB) verbunden ist. Der Zugriff auf die betreffende Bitleitung erfolgt durch ein die Torschaltung aufsteuerndes Spalten-Auswahlsignal (SAS). Zur Erleichterung des Schreibbetriebs ist eine Schalteinrichtung (T9) vorgesehen, die nach Erregung einer beliebigen zeilenbezogenen Wortleitung die Stromversorgung der für einen Zugriff ausgewählten Latch-Flipflops (T1-T4) ab einem Zeitpunkt unterbricht, der nicht früher ist, als bis das betreffende Latch-Flipflop einen den Informationsinhalt der zugegriffenen Speicherzelle anzeigenden Zustand eingenommen hat, und der spätestens in das aktive Intervall des betreffenden Spalten-Auswahlsignals fällt.

## Beschreibung

Die Erfindung betrifft eine Schaltungsanordnung zum Lesen und Schreiben binärer Information an einem Speicherzellenfeld, das eine matrixförmige Anordnung aus Zeilen und Spalten von Speicherzellen bildet, gemäß dem Oberbegriff des Patentanspruchs 1. Bevorzugtes, aber nicht ausschließliches Anwendungsgebiet der Erfindung sind dynamische RAM-Speicher (DRAMs).

Bei den üblichen Speichermatrizen erfolgt der Zugriff auf eine beliebige Speicherzelle durch Erregung einer der betreffenden Zeile zugeordneten Wortleitung und durch Ansteuern einer der betreffenden Spalte zugeordneten Bitleitung. Letzteres geschieht über Schreib/Lese-Schaltungen, welche im Schreibbetrieb Informationsbits aus einer Nachrichtenquelle an die Bitleitungen übertragen und im Lesebetrieb Informationsbits von den Bitleitungen an eine Nachrichtensenke übertragen. Da sich die Ladungszustände der Speicherzellen, welche die Binärwerte "0" und "1" der gespeicherten Information beschreiben, nur um eine sehr geringe Pegeldifferenz unterscheiden, sind die Schreib/Lese-Schaltungen so auszubilden, daß sie beim Lesen eine Verstärkung bewirken; aus diesem Grund werden diese Schaltungen im folgenden auch kurz als "Leseverstärker" bezeichnet, wie allgemein üblich, selbst wenn sie zu Schreibzwecken mitverwendet werden.

Die derzeit gebräuchlichen Leseverstärker sind als sogenannte Latch-Flipflops ausgebildet, d.h. als transistorisierte bistabile Kippschaltungen, die umschaltbar sind zwischen zwei definierten Extremzuständen, welche die Binärwerte "0" und "1" repräsentieren. Jeder dieser entgegengesetzten Zustände kann ausgelöst werden durch Aufbauen einer triggernden Spannung der einen oder anderen Polarität an einem Datenanschluß, wodurch die Schaltung in einen sich selbst haltenden Extremzustand getrieben wird, bei welchem der Datenanschluß auf (oder nahe an) das eine oder das andere Potential der Versorgungsspannung gezogen ist. Somit wird der Datenanschluß auf einen durch die Polarität der Triggerspannung diktierten Binärwert verriegelt (der Binärwert wird "gelatcht"), und das betreffende Binärdatum kann mit genügender Stärke und Ausdauer weitergereicht werden.

Üblicherweise ist der Datenanschluß des im Leseverstärker enthaltenen Latch-Flipflops einerseits mit einer zugeordneten Bitleitung und andererseits über eine durch ein Spalten-Auswahlsignal aufsteuerbare Torschaltung mit der Datenleitung verbunden, die zur Nachrichtenquelle bzw. Nachrichtensenke führt. Im Falle gepaarter differenzieller Bitleitungen, wo jeder Bitleitungspfad ein differenzielle Pärchen zweier Bitleitungen und der Datenleitungspfad ebenfalls ein differenzielles Paar zweier Datenleitungen bildet, sind die Latch-Flipflops wie ein Differenzverstärker mit zwei Datenanschlußpunkten versehen, deren jeder einerseits mit einem zugeordneten Exemplar der das betreffende Paar bildenden Bitleitungen und andererseits über eine jeweils zugeordnete Torschaltungshälfte mit einem zugeordneten Exemplar der beiden Datenleitungen verbunden ist.

Zum Lesen und Schreiben an einer Speicherzelle wird nach Erregung der betreffenden Wortleitung zumindest der für die betreffende Spalte zuständige Leseverstärker eingeschaltet, so daß, je nach dem Ladezustand der Zelle, über die zuständige Bitleitung Strom zum Aufbauen der Triggerspannung am Datenanschluß des Latch-Flipflops fließt, welches daraufhin den Binärzustand annimmt, welcher den Informationsinhalt Zelle repräsentiert. Das Potential des Datenanschlusses wird hierdurch auf den die Information anzeigenden Pegel gezogen. Dann wird das Spalten-Auswahlsignal angelegt, um den Datenanschluß über die Torschaltung mit der Datenleitung zu verbinden. Im Lesebetrieb wird das Potential des Datenanschlusses von der Datenleitung übernommen. Im Schreibbetrieb wird der Datenleitung von außen der Pegel für die einzuschreibende Information aufgeprägt, der über den Datenanschluß das Latch-Flipflop kippen muß, wenn dessen bisheriger Binärzustand nicht der einzuschreibenden Information entspricht (wenn also der bisherige Zelleninhalt geändert werden soll).

Die Ansprechempfindlichkeit des Leseverstärkers im Lesebetrieb, also seine Spannungs/Strom-Verstärkung (Transkonduktanz), hängt von der Verstärkung der im Latch-Flipflop enthaltenen Transistoren ab. Je höher diese Verstärkung ist, desto schneller und zuverlässiger kann das Latch-Flipflop durch den kleinen Strom, den eine selektierte Speicherzelle liefert, aus seinem unverriegelten Anfangszustand in einen der beiden stabilen Binärzustände gekippt und verriegelt werden. Es ist daher das Bestreben des Konstrukteurs, den Leseverstärker möglichst stark auszulegen, um hohe Lesegeschwindigkeiten zu erzielen. Hierdurch kann es sich aber ergeben, daß das Schreiben der Information aus dem Datenleitungspfad in das Zellenfeld schwierig oder unmöglich wird. Dies liegt in der oben beschriebenen Tatsache begründet, daß beim Schreiben das Latch-Flipflop eventuell in einen anderen Zustand gekippt werden muß, der Leseverstärker also "umgeschrieben" werden muß. Wenn dieser aber sehr stark dimensioniert ist, wird es schwierig oder erfordert lange Zeit, das Latch-Flipflop aus einem eingenommenen Binärzustand in den anderen zu kippen, zumal die Torschaltung, über welche die Schreibinformation von der Datenleitung in das Latch-Flipflop läuft, strombegrenzend ist.

Bisher wurde dieses Problem, das insbesondere bei sehr schnellen DRAMs gravierend ist, durch sehr starke Dimensionierung der die einzuschreibenden Pegel erzeugenden Schreibtreiber gelöst. Wenn die Leseverstärker aber immer stärker ausgelegt werden, wird dieses Vorgehen immer ungünstiger, da die Treiber immer größer und langsamer werden und immer mehr Strom verbrauchen.

Eine andere Lösung wäre die Verwendung einer speziellen Schreibschaltung im Leseverstärker. Dies wäre jedoch mit erheblichem Flächenaufwand verbunden.

Aus der U.S. 4 435 793 ist eine Schaltanordnung zum Lesen binärer Informationen aus einem Speicherzellenfeld bekannt, die eine Schreib-/Leseschaltung mit Latch-Flipflop beinhaltet, das eine Schalteinrichtung zum Aktivieren/Deaktivieren des Flipflops und eine weitere dazu in Reihe geschaltete Schalteinrichtung besitzt, die von einem Spaltendekoder angesteuert wird.

Die Aufgabe der Erfindung besteht darin, bei geringem Schaltungs- und Energieaufwand und ungeachtet der Leseverstärkung ein problemloses Schreiben von Information an einem Speicherzellenfeld zu ermöglichen. Diese Aufgabe wird erfindungsgemäß durch die im Patentanspruch 1 beschriebene Schaltungsanordnung gelöst. Vorteilhafte Ausgestaltungen und Weiterbildungen der Erfindung sind in den Unteransprüchen gekennzeichnet.

Demnach geht die Erfindung von einer Schaltungsanordnung zum Lesen und Schreiben binärer Information an einem Speicherzellenfeld aus, das eine matrixförmige Anordnung aus Zeilen und Spalten von Speicherzellen bildet, wobei der Zugriff auf eine beliebige Speicherzelle durch Erregung einer der betreffenden Zeile zugeordneten Wortleitung und durch Ansteuern einer der betreffenden Spalte zugeordneten Bitleitung über eine jeweils zugeordnete Schreib/Lese-Schaltung erfolgt, und wobei jede Schreib/Lese-Schaltung ein Latch-Flipflop mit mindestens einem Datenanschluß enthält, der einerseits mit einer zugeordneten Bitleitung und andererseits über eine durch ein Spalten-Auswahlsignal aufsteuerbare Torschaltung mit einer Datenleitung verbunden ist. Erfindungsgemäß ist eine Schalteinrichtung vorgesehen, die nach Erregung einer beliebigen Wortleitung die Stromversorgung der Latch-Flipflops in den durch ein Spalten-Auswahlsignal anzusteuernden Schreib/Lese-Schaltungen ab einem Zeitpunkt unterbricht, der nicht früher ist, als bis das betreffende Latch-Flipflop einen den Informationsinhalt der zugegriffenen Speicherzelle anzeigenden Zustand eingenommen hat, und der spätestens in das aktive Intervall des betreffenden Spalten-Auswahlsignals fällt.

Die Erfindung beinhaltet also eine sehr einfache Schaltungsmaßnahme, die lediglich für eine Abschaltung der Stromversorgung der für einen Zugriff auszuwählenden Latch-Flipflops zu einem geeigneten Zeitpunkt sorgt, nachdem sich das Latch-Flipflop auf den durch den Zelleninhalt bestimmten Binärzustand eingestellt hat und bevor ein eventueller Schreibbetrieb einsetzen würde. Diese Abschaltung verhindert, daß beim Schreiben gegen die Leseverstärkung angegangen werden muß; somit ist die Anstrengung beim Schreiben unabhängig von der Leseverstärkung.

Vorzugsweise enthält die erfindungsgemäß vorgesehene Schalteinrichtung einen Unterbrechungsschalter in jeder Schreib/Lese-Schaltung, der angeordnet ist zum Unterbrechen der Verbindung zwischen einem Versorgungspotential und dem betreffenden Latch-Flipflop. Zur Realisierung bedarf es also nur eines zusätzlichen Elementes, z.B. eines Feldeffekttransistors (FET), pro Bitleitung (bzw. pro Bitleitungspaar im Falle gepaarter Bitleitungen). Es sind keine weiteren Schaltungen im Bereich der Schreib/Lese-Schaltung nötig, so daß der Flächenaufwand minimal ist. Bei geeigneter Auslegung des Unterbrechungsschalters kann zu seiner Ansteuerung direkt das Spalten-Auswahlsignal der betreffenden Schreib/Lese-Schaltung verwendet werden, um die Unterbrechung der Stromversorgung mit Beginn dieses Spalten-Auswahlsignals einzuleiten und für die Dauer des Spalten-Auswahlsignals aufrechtzuerhalten. Dies hat den Vorteil, daß keine zusätzlichen Leitungen in die Schreib/Lese-Schaltung geführt werden müssen.

In besonderer Ausgestaltung der Erfindung kann durch zusätzliche verriegelnde Schaltungsteile an der Datenleitung sichergestellt werden, daß auch bei relativ langen Unterbrechungen der Stromversorgung der Latch-Flipflops, etwa bei Verwendung langer Spalten-Auswahlimpulse, keine Information verloren geht. Bei Verwendung von Datenleitungen, die jeweils mehreren Schreib/Lese-Schaltungen gemeinsam sind, sind diese Schaltungsteile aber nur einmal pro Datenleitung in der Peripherie erforderlich.

Das mit der Erfindung zu lösende Problem und die Erfindung selbst werden nachstehend anhand von Zeichnungen näher erläutert. Es zeigen:
Fig. 1 das Schaltbild eines Leseverstärkers nach dem Stand der Technik;
Fig. 2 das Schaltbild eines Leseverstärkers, der gemäß einer Ausführungsform der Erfindung ausgebildet ist; und
Fig. 3 eine Schaltungsanordnung, die mehrere erfindungsgemäße Leseverstärker nach Fig. 1 mit einer gemeinsamen Zusatzeinrichtung enthält.

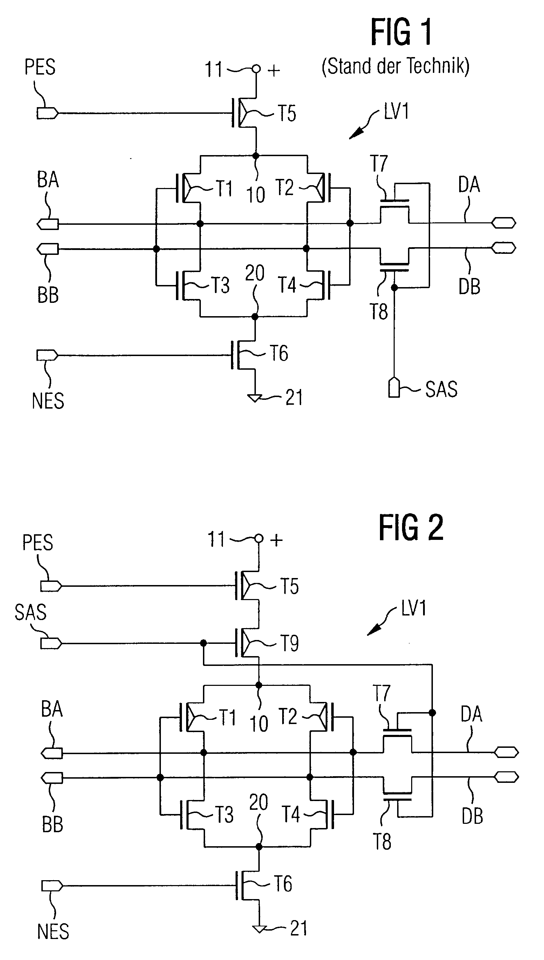

Zur Erläuterung des mit der Erfindung zu lösenden Problems sei zunächst auf die Fig. 1 Bezug genommen, die eine typische Bauform eines Leseverstärkers nach dem Stand der Technik zeigt.

Der insgesamt mit LV1 bezeichnete bekannte Leseverstärker nach Fig. 1 enthält ein erstes Transistorpaar, bestehend aus zwei p-Kanal-Feldeffekttransistoren (P-FETs) T1 und T2, und ein zweites Transistorpaar, bestehend aus zwei n-Kanal-Feldeffekttransistoren (N-FETs) T3 und T4. Die ersten Hauptelektroden der P-FETs T1 und T2, im dargestellten Fall die Sourceelektroden, sind an einem Schaltungspunkt 10 zusammengekoppelt, der über die Schaltstrecke eines ersten Transistorschalters T5 mit einem ersten Stromversorgungsanschluß 11 verbunden ist, welcher im dargestellten Fall das positive Potential einer (nicht dargestellten) Stromversorgungsquelle empfängt. Die Sourceelektroden der N-FETs T3 und T4 sind an einem Schaltungspunkt 20 zusammengekoppelt, der über die Schaltstrecke eines zweiten Transistorschalters T6 mit einem zweiten Stromversorgungsanschluß 11 verbunden ist, welcher im dargestellten Fall das Referenzpotential (z.B. Massepotential) der Stromversorgungsquelle empfängt. Im dargestellten Fall ist der erste Transistorschalter T5 ein P-FET, und der zweite Transistorschalter T6 ist ein N-FET.

Die zweiten Hauptelektroden der Transistoren T1 und T3, im dargestellten Fall die Drainelektroden, und die Gateelektroden der Transistoren T2 und T4 sind alle mit einem ersten Datenanschluß BA verbunden, der zu einer der beiden Bitleitungen eines differenziellen Bitleitungs-Pärchens führt, welches dem Leseverstärker LV1 speziell zugeordnet ist. In ähnlicher Weise sind Drainelektroden der Transistoren T2 und T4 und die Gateelektroden der Transistoren T1 und T3 alle mit einem zweiten Datenanschluß BB verbunden, der zu der anderen Bitleitung des differenziellen Pärchens führt. Die beiden Datenanschlüsse BA und BB sind außerdem über jeweils einen Torschaltungstransistor T7 bzw. T8, im dargestellten Fall jeweils ein N-FET, mit einer jeweils zugeordneten Datenleitung DA bzw. DB verbunden, die im dargestellten Ausführungsbeispiel ein differenzielles, bidirektionales Datenleitungspaar bilden. Die vier Transistoren T1 bis T4 bilden ein Latch-Flipflop, das bei wirksamer Stromversorgung, also wenn die beiden Transistoren T5 und T5 leitend sind, in den einen oder anderen zweier stabiler (Binär-)Zustände triggerbar ist, um die an die Datenanschlüsse BA und BB gelegte Binärinformation aufzufangen und zu halten, wie nachstehend beschrieben.

Im hier behandelten Fall gepaarter Bitleitungen enthält jede Zeile des Speicherzellenfeldes jeweils zwei Speicherzellen pro Spaltenposition, von denen die eine den "wahren" Binärwert und die andere den "komplementären" Binärwert speichert. Jede dieser beiden Zellen ist mit einem jeweils zugeordneten Exemplar der beiden Bitleitungen des zur betreffenden Spalte gehörenden Bitleitungs-Pärchens verbunden. Mit Erregung einer Wortleitung werden die Zellenpaare der betreffenden Zeile an die jeweiligen Bitleitungspärchen gekoppelt, so daß zwischen den beiden Bitleitungen des Pärchens eine Potentialdifferenz mit einer die gespeicherte Information darstellenden Polarität entsteht. Diese Potentialdifferenz erscheint an den Datenanschlüssen BA und BB des dem betreffenden Pärchen zugeordneten Leseverstärkers.

Im Betrieb wird der Leseverstärker LV1 kurz nach Erregung einer Wortleitung eingeschaltet, indem die beiden Transistorschalter T5 und T6 durch ein jeweils zugeordnetes Einschaltsignal PES bzw. NES leitend gemacht werden. Das gleiche geschieht zur selben Zeit auch mit allen anderen Leseverstärkern (nicht gezeigt) des Zellenfeldes, die an die anderen Bitleitungspärchen angeschlossen sind und in ihrem Aufbau dem in Fig. 1 dargestellten Leseverstärker LV1 entsprechen. Hat nun die Potentialdifferenz an den Datenanschlüssen eine solche Polarität, daß BA positiv gegenüber BB ist, dann werden die Transistoren T1 und T4 in Richtung zunehmender Leitfähigkeit und die Transistoren T3 und T3 in Richtung zunehmender Sperrung getrieben, so daß BA auf das positive Versorgungspotential des Anschlusses 11 und BB auf das am Anschluß 21 herrschende Referenzpotential gezogen wird. Infolge der Mitkopplung zwischen T1 und T4 und zwischen T2 und T3 bzw. der Gegenkopplung zwischen T1 und T2 und zwischen T3 und T4 beschleunigt sich dieser Vorgang und führt zur Verriegelung des Endzustandes. Ist hingegen BA im Augenblick der Einschaltung des Leseverstärkers negativ gegenüber BB, dann ergibt sich der entgegengesetzte Endzustand, in welchem BA auf das Referenzpotential und BB auf das positive Versorgungspotential gezogen ist. Die im jeweiligen Endzustand "auseinandergezogene" Potentialdifferenz zwischen den Datenanschlüssen BA, BB wird über das angeschlossene Bitleitungs-Pärchen an das betreffende Zellenpaar zurückgeschrieben, dessen Speicherinformation auf diese Weise aufgefrischt wird. Die Einschaltsignale PES und NES werden erst bei Aberregung der Wortleitung wieder fortgenommen.

Der jeweilige Endzustand, also der eine oder andere stabile Binärzustand des Latch-Flipflops T1-T4, ist nach Ablauf des sogenannten "Bewertungsintervalls" erreicht, dessen Länge u.a. von der Dimensionierung des Leseverstärkers LV1 abhängt und umso kürzer ist, je höher dessen Verstärkung ist. Am Ende dieses Intervalls wird an den Leseverstärker, wenn er für einen Schreib- oder Lesezugriff ausgewählt werden soll, ein Spalten-Auswahlsignal SAS gelegt, welches die Torschaltungstransistoren T7 und T8 leitend macht und somit die vom Latch-Flipflop T1-T4 in der beschriebenen Weise "auseinandergezogene" Potentialdifferenz der Datenanschlüsse BA, BB auf die Datenleitungen DA, DB koppelt. Die hierdurch dargestellte Information kann dann an den Datenleitungen von einer (nicht gezeigten) Verarbeitungseinrichtung gelesen werden. Zum Einschreiben einer Information wird stattdessen während des Spalten-Auswahlpulses SAS, also bei geöffneter Torschaltung T7-T8, die der einzuschreibenden Information entsprechende Potentialdifferenz von außen an die Datenleitungen gelegt. Ist diese Information gleich der bisherigen Speicherinformation, ändert sich nichts am Schaltzustand des Latch-Flipflops T1-T4. Ist die neue Information jedoch der entgegengesetzte Binärwert (umgekehrte Potentialdifferenz), dann muß das Latch-Flipflop T1-T4 in den anderen Schaltzustand geworfen werden.

Bei dem in Fig. 1 gezeigten bekannten Leseverstärker LV1 ist dieses Umwerfen des Latch-Flipflops T1-T4 relativ schwer, weil hierbei gegen die Verstärkung des eingeschalteten Latch-Flipflops angegangen werden muß, und zwar über die naturgemäß strombegrenzende Torschaltung T7-T8. Gemäß der vorliegenden Erfindung wird dieses Problem dadurch beseitigt, daß Vorkehrungen getroffen sind, um die Stromversorgung des Latch-Flipflop während der Zeit eines möglicherweise durchzuführenden Schreibvorgangs vorübergehend zu unterbrechen. Die Fig. 2 zeigt an einem Ausführungsbeispiel, wie dies realisiert werden kann.

Der in Fig. 2 dargestellte erfindungsgemäße Leseverstärker LV2 gleicht demjenigen nach Fig. 1, mit dem einzigen Unterschied, daß ein zusätzlicher Transistorschalter T9 in einen der Stromversorgungszweige des Latch-Flipflops eingefügt ist. Alle anderen Elemente des Leseverstärkers LV2, die in Aufbau und Funktion den Elementen des in Fig. 1 gezeigten Leseverstärkers LV1 entsprechen, sind mit den gleichen Bezugszeichen wie dort bezeichnet und brauchen nicht erneut beschrieben zu werden.

Im Leseverstärker LV2 nach Fig. 2 ist der zusätzliche Transistorschalter T9 ein P-FET, dessen Source-Drain-Strecke (Kanal) in Reihe mit dem Transistorschalter T5 zwischen dem positiven Versorgungsanschluß 11 und den zusammengekoppelten Sourceelektroden der P-FETs T1, T2 des Latch-Flipflops T1-T4 liegt und dessen Gateelektrode das Spalten-Auswahlsignal SAS empfängt, welches auch den Torschaltungstransistoren T7, T8 angelegt wird. Dies bewirkt, daß der zusätzliche Transistorschalter T9 sperrt, sobald und solange die Torschaltung T7-T8 durchlässig ist.

Wenn also nach Erregung einer Wortleitung, Einschaltung der Stromversorgung über die Transistorschalter T5, T6 und nach Ablauf des Bewertungsintervalls das Latch-Flipflop T1-T4 in der weiter oben beschriebenen Weise seinen durch die Speicherinformation bestimmten Binärzustand eingenommen hat und das Spalten-Auswahlsignal SAS erscheint, wird die Torschaltung T7-T8 durchlässig, und das Latch-Flipflop wird vom positiven Versorgungsanschluß 11 abgetrennt. Das nunmehr schwebende Potential am Schaltungspunkt 10 behält jedoch noch über eine gewisse Zeit einen genügend positiven Wert, um die Potentialdifferenz zwischen den Datenanschlüssen BA, BB so weit aufrechtzuerhalten, daß die von ihr dargestellte Information im Falle eines Lesebetriebs über die durchlässige Torschaltung T7-T8 an den Datenleitungen DA, DB gelesen werden kann. Anderseits bewirkt die Unterbrechung der Stromversorgung, daß das Latch-Flipflop seine Verstärkerfunktion verliert. Somit wird es leichter, im Falle eines Schreibbetriebs das Latch-Flipflop T1-T4 durch eine entgegengesetzte Potentialdifferenz von den Datenleitungen DA, DB her umzuwerfen.

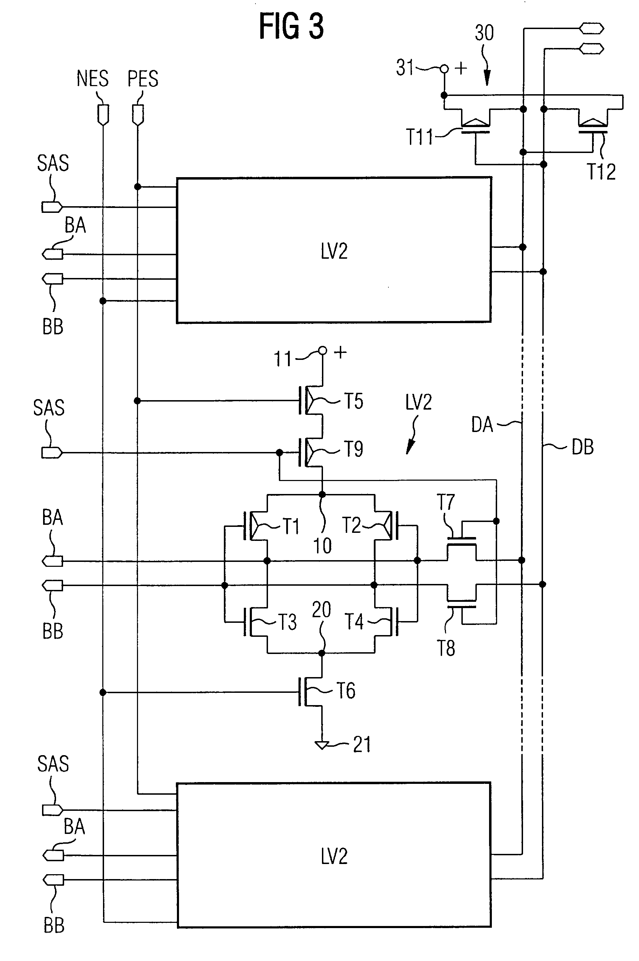

Nur wenn das Spalten-Auswahlsignal SAS und somit die Unterbrechung der Stromversorgung relativ lange dauert, kann sich im Falle eines Lesebetriebs die zu lesende Potentialdifferenz so weit abbauen, daß ein zuverlässiges Lesen nicht mehr möglich ist. Für solche Fälle kann in einer besonderen Ausführungsform der Erfindung eine zusätzliche Stütze zur Bewahrung der zu lesenden Potentialdifferenz an den Datenleitungen DA, DB vorgesehen werden. Diese Stütze kann ein zusätzliche Verriegelungsschaltung (Latch) sein. Der Aufwand hierfür ist tragbar, wenn eine gemeinsame Datenleitung für mehrere Leseverstärker verwendet wird, was üblicherweise der Fall ist. Ein Ausführungsbeispiel zeigt die Fig. 3.

Gemäß der Fig. 3 ist eine Mehrzahl von Leseverstärkern LV2 der in Fig. 2 gezeigten Bauform an ein gemeinsames Datenleitungspaar DA, DB angeschlossen. Nur einer dieser Leseverstärker LV2 ist im Detail dargestellt, die anderen sind durch Blöcke symbolisiert und haben den gleichen Aufbau, und jeder ist mit einem eigenen Bitleitungs-Pärchen verbunden. Die Einschaltsignale PES und NES werden allen Leseverstärkern gemeinsam angelegt. Während eines Lese- oder Schreibzyklus werden die einzelnen Leseverstärker, nach Erregung einer Wortleitung und Anlegen der Einschaltsignale PES und NES, getrennt in verschiedenen Zeitschlitzen durch selektiv angelegte Spalten-Auswahlsignale SAS angesteuert, um Informationen zeitlich nacheinander über das gemeinsame Datenleitungspaar DA, DB auszulesen bzw. einzuschreiben.

An das Datenleitungspaar DA, DB ist eine Latch-Schaltung angeschlossen, die zwei Transistoren T11 und T12 enthält und praktisch eine Hälfte des Latch-Flipflops eines Leseverstärkers LV2 nachbildet, und zwar diejenige welche durch die erfindungsgemäße Unterbrechung der Stromversorgung von einem Festpotential der Versorgungsspannung abgetrennt wird. Beim dargestellten Ausführungsbeispiel sind die Transistoren T11 und T12 P-FETs, deren Sourceelektroden zusammengekoppelt und mit dem positiven Potential der Versorgungsquelle verbunden sind, ähnlich den Transistoren T1 und T2 des Latch-Flipflops eines Leseverstärkers LV2. Die Drainelektrode des Transistors T11 und die Gateelektrode des Transistors T12 sind mit der Datenleitung DA verbunden, während die Drainelektrode des Transistors T12 und die Gateelektrode des Transistors T11 mit der Datenleitung DB verbunden sind. Diese Verschaltung entspricht der Verschaltung der Transistoren T1 und T2 mit den Datenanschlüssen BA und BB.

Sobald infolge eines Spalten-Auswahlsignals SAS die Torschaltungstransistoren T7, T8 eines Leseverstärkers LV2 durchlässig werden und das positive Versorgungspotential von den Transistoren T1 und T2 des betreffenden Latch-Flipflops abgetrennt wird, übernehmen die Transistoren T11 und T12, die bleibend am positiven Versorgungspotential liegen, die vorherige Rolle der Transistoren T1 und T2. Hierdurch bleibt die zu lesende Potentialdifferenz zwischen den Datenleitungen DA und DB für einen zuverlässigen Lesebetrieb erhalten.

Neben den vorstehend anhand der Figuren 2 und 3 beschriebenen Anordnungen, die lediglich Ausführungsbeispiele der Erfindung darstellen, sind auch Abwandlungen und andere Ausführungsformen zur Realisierung des Erfindungsgedankens möglich. So kann als Verriegelungsschaltung 30 auch irgendeine andere Halteschaltung verwendet werden.

Zum Unterbrechen der Stromversorgung am Leseverstärker nach Ablauf des Bewertungsintervalls kann statt des Spalten-Auswahlsignals SAS gewünschtenfalls ein besonderes, eigens zu diesem Zweck erzeugtes Unterbrechungs-Steuersignal verwendet werden. Vorteilhaft kann es sein, die erfindungsgemäße Unterbrechung der Stromversorgung etwas verzögert gegenüber der Vorderflanke des Spalten-Auswahlsignals SAS zu beginnen, so daß im Falle eines Lesebetriebs die zu lesende Information mit größerer Leistung auf die Datenleitungen gekoppelt wird. Dies kann durch entsprechende Zeitverzögerung eines besonderen Unterbrechungs-Steuersignals oder durch Ansprechverzögerung des Unterbrechungsschalters T9 erreicht werden. Allgemein gilt, daß der Zeitpunkt des Beginns der Unterbrechung nicht früher sein soll, als bis das betreffende Latch-Flipflop einen den Informationsinhalt der zugegriffenen Speicherzelle anzeigenden Zustand eingenommen hat, und daß dieser Zeitpunkt spätestens noch rechtzeitig in das aktive Intervall des betreffenden Spalten-Auswahlsignals fällt, um während dieses Intervalls noch genügend Zeit für einen Schreibbetrieb zu haben.

Die zur Abschaltung der Stromversorgung des Leseverstärkers verwendete Schalteinrichtung kann auch an anderer Stelle angeordnet sein, als es mit dem Transistor T9 in Fig. 2 oder 3 gezeigt ist, z.B. als Unterbrechungsschalter im Wege der Zuleitung vom Referenzpotential-Anschluß 21 zum Latch-Flipflop T1-T4. In diesem Fall wären die Transistoren T11 und T12 der in Fig. 3 gezeigten Verriegelungsschaltung 30 als N-FETs auszubilden und mit ihren Sourceelektroden an das Referenzpotential anzuschließen. Die Schalteinrichtung kann auch so ausgebildet bzw. angeordnet sein, daß sie zumindest einen der vorhandenen Einschalttransistoren T5, T6 sperrt, etwa unter Verwendung eines geeigneten Schalttransistors im Steuerkreis dieser Transistoren.

Schließlich sei erwähnt, daß die Erfindung weder auf die in den Figuren dargestellte spezielle Bauform des Leseverstärkers noch auf die Verwendung gepaarter Bit- und Datenleitungen beschränkt ist. Im Falle "eindrahtiger" Bit- und Datenleitungspfade hat das Latch-Flipflop des Leseverstärkers nur einen Datenanschluß, dessen Potential gegenüber einem festen Bezugspotential den Binärzustand des Flipflops bestimmt bzw. anzeigt. Das Flipflop kann in diesem Fall einfacher ausgebildet sein, als es in den Figuren gezeigt ist. Die Erfindung kann mit Erfolg bei jeder Art von "latchenden" Leseverstärkern angewandt werden.

## Patentansprüche

1. Schaltungsanordnung zum Lesen und Schreiben binärer Information an einem Speicherzellenfeld, das eine matrixförmige Anordnung aus Zeilen und Spalten von Speicherzellen bildet,
wobei der Zugriff auf eine beliebige Speicherzelle durch Erregung einer der betreffenden Zeile zugeordneten Wortleitung und durch Ansteuern einer der betreffenden Spalte zugeordneten Bitleitung über eine jeweils zugeordnete Schreib/Lese-Schaltung (LV2) erfolgt,
und wobei jede Schreib/Lese-Schaltung (LV2) ein Latch-Flipflop (T1-T4) mit mindestens einem Datenanschluß (BA, BB) enthält, der einerseits mit einer zugeordneten Bitleitung und andererseits über eine durch ein Spalten-Auswahlsignal (SAS) aufsteuerbare Torschaltung (T7, T8) mit einer Datenleitung (DA bzw. DB) verbunden ist,
**gekennzeichnet durch**
eine Schalteinrichtung (T9), die nach Erregung einer beliebigen Wortleitung die Stromversorgung der Latch-Flipflops (T1-T4) in den **durch** ein Spalten-Auswahlsignal (SAS) anzusteuernden Schreib/Lese-Schaltungen (LV2) ab einem Zeitpunkt unterbricht, der nicht früher ist, als bis das betreffende Latch-Flipflop einen den Informationsinhalt der zugegriffenen Speicherzelle anzeigenden Zustand eingenommen hat, und der spätestens in das aktive Intervall des betreffenden Spalten-Auswahlsignals fällt.

2. Schaltungsanordnung nach Anspruch 1, **dadurch gekennzeichnet, dass** die Schalteinrichtung einen Unterbrechungsschalter (T9) in jeder Schreib/Lese-Schaltung (LV2) enthält, der angeordnet ist zum Unterbrechen der Verbindung zwischen einem Versorgungspotential (+) und dem betreffenden Latch-Flipflop (T1-T4).

3. Schaltungsanordnung nach Anspruch 2, **dadurch gekennzeichnet, daß** jeder Unterbrechungsschalter (T9) auf das Spalten-Auswahlsignal (SAS) der betreffenden Schreib/Lese-Schaltung (LV2) anspricht, um die Unterbrechung der Stromversorgung mit Beginn dieses Spalten-Auswahlsignals einzuleiten und für die Dauer des Spalten-Auswahlsignals aufrechtzuerhalten.

4. Schaltungsanordnung nach Anspruch 2 oder 3, in welcher jedes Latch-Flipflop (T1-T4) ein erstes Transistorpaar (T1, T2) enthält, bei dem die Steuerelektrode jedes Transistors mit einer Hauptelektrode des jeweils anderen Transistors verbunden ist und die Steuerelektrode eines der Transistoren (T1 bzw. T2) mit einem Datenanschluß (BB bzw. BA) des Latch-Flipflops verbunden ist und die anderen Hauptelektroden der beiden Transistoren mit einem Schaltungspunkt (10) zum Empfang eines ersten Versorgungspotentials (+) verbunden sind, **dadurch gekennzeichnet,**
**daß** der Unterbrechungsschalter (T9) zwischen dem genannten Schaltungspunkt (10) und einem das erste Versorgungspotential (+) empfangenden Versorgungsanschluß (11) der betreffenden Schreib/Lese-Schaltung (LV2) angeordnet ist.

5. Schaltungsanordnung nach einem der Ansprüche 1 bis 4, in welcher die Datenleitung (DA bzw. DB) mehreren Schreib/Lese-Schaltungen (LV2) gemeinsam ist, **dadurch gekennzeichnet,**
**daß** mit der Datenleitung (DA bzw. DB) eine Verriegelungsschaltung (30) verbunden ist, die den Binärzustand des Datenanschlusses (BA bzw. BB) eines Latch-Flipflops (T1-T4), der von der zugeordneten Torschaltung auf die Datenleitung gekoppelt wird, an der Datenleitung verriegelt.

6. Schaltungsanordnung nach den Ansprüchen 4 oder 5, **dadurch gekennzeichnet,**
**daß** die Verriegelungsschaltung (30) ein Transistorpaar (T11, T12) aufweist, das hinsichtlich des Leitungstyps dem ersten Transistorpaar (T1, T2) gleicht und bei dem die Steuerelektrode jedes Transistors mit einer Hauptelektrode des jeweils anderen Transistors verbunden ist und die Steuerelektrode eines der Transistoren mit der genannten gemeinsamen Datenleitung verbunden ist und die anderen Hauptelektroden der beiden Transistoren mit einem das erste Versorgungspotential (+) empfangenden Versorgungsanschluß (31) verbunden sind.
